# EUROPÄISCHE PATENTSCHRIFT

(11) **EP 3 887 837 B1**
(45) Veröffentlichungstag und Bekanntmachung des Hinweises auf die Patenterteilung: **26.04.2023**
(21) Anmeldenummer: 19801557.0
(22) Anmeldetag: 11.11.2019
(51) Int. Cl.: G01R 31/392, H02J 7/00

(54) **VERFAHREN UND VORRICHTUNG ZUR ABSCHÄTZUNG DES GESUNDHEITSZUSTANDS EINES WECHSELAKKUS**
METHOD AND DEVICE FOR ESTIMATING THE STATE OF HEALTH OF AN EXCHANGEABLE RECHARGEABLE BATTERY
PROCÉDÉ ET DISPOSITIF D'ESTIMATION DE L'ÉTAT DE SANTÉ D'UNE BATTERIE RECHARGEABLE

(30) Priorität: 26.11.2018 DE 102018220251
(43) Veröffentlichungstag der Anmeldung: 06.10.2021
(73) Patentinhaber: Robert Bosch GmbH, 70442 Stuttgart (DE)
(72) Erfinder: GONSER, Andreas, 72649 Wolfschlugen (DE); NICKLAUS, Mischa, 70193 Stuttgart (DE); SEIBERT, Marc-Alexandre, 70567 Stuttgart (DE)
(86) Internationale Anmeldenummer: PCT/EP2019/080845
(87) Internationale Veröffentlichungsnummer: WO 2020/108970

(56) Entgegenhaltungen:
- EP-A1- 3 109 654
- DE-A1- 10 056 971
- US-A1- 2018 088 181

## Beschreibung

### Beschreibung

Die Erfindung betrifft ein Verfahren zur Abschätzung des Gesundheitszustands eines Wechselakkus, insbesondere eines Wechselakkupacks für Elektrowerkzeuge, sowie ein Ladegerät und einen Wechselakku zur Durchführung des Verfahrens nach der Gattung der unabhängigen Ansprüche.

### Stand der Technik

Wiederaufladbare Batterien - oder im folgenden auch Akkus genannt - werden in vielen Bereichen eingesetzt; entweder fest im Gerät integriert oder als Wechselakku bzw. Wechselakkupack. Wechselakkus werden in der Regel vom Hersteller für eine spezifische Anwendung angeboten. Ebenso kommt es aber auch sehr häufig vor, dass Wechselakkus derselben Leistungs- oder Spannungsklasse für eine Vielfalt verschiedener Geräte anwendbar sind. Dies ist besonders im Bereich der Elektrowerkzeuge, Haushalts- und Gartengeräte der Fall. Im Folgenden sollen die Begriffe Batterie, Akku, Wechselakku oder Wechselakkupack hinsichtlich ihrer Technologie und im Rahmen der vorliegenden Erfindung als Synonom verstanden werden.

Charakteristisch für Akkus sind die folgenden Parameter:
- Die verwendete Zellentechnologie (Chemie), wie z.B. Li-Ion, Li-Polymer, Li-Metal, Ni-Cd, Ni-MH, usw.
- Die Spannung (maximale/nominelle/minimale Spannung). Sie ergibt sich aus der Zellentechnologie und aus der Anzahl an Akkuzellen, die im Akku in Reihe geschaltet sind.
- Die Kapazität. Diese wird typischerweise in Ampere-Stunden (Ah) angegeben und bezeichnet die Ladung, die der Akku enthalten kann. Sie berechnet sich aus der Kapazität einer einzelnen Akkuzelle und aus der Anzahl an Ackuzellen, die im Akku parallel geschaltet sind. Bei gegebener Akkuspannung bedeutet eine höhere Kapazität, dass die Batterie mehr Energie speichern kann.
- Die Leistungsfähigkeit. Sie wird zum Beispiel als maximaler Strom, den der Akku liefern kann, angegeben. Da die Akkuzellen sich bei hohen Strömen erwärmen und nur in einem bestimmten Temperaturbereich betrieben werden dürfen, kann die Leistungsfähigkeit des Akkus auch durch einen Strom, den der Akku für eine bestimmte Zeit oder bis zur kompletten Entladung liefern kann, beschrieben werden. Die Leistungsfähigkeit ist sehr stark abhängige von der Impedanz (Innenwiderstand) des Akkus.

Kapazität und Leistungsfähigkeit können sich über die Lebensdauer des Akkus durch verschiedene Alterungsmechanismen ändern. Typischerweise verliert ein Akku im Laufe seines Lebenszyklus an Kapazität und Leistungsfähigkeit, was direkten Einfluss auf seinen "Gesundheitszustand" hat. Der akute Gesundheitszustand eines Akkus wird oft auch als "State of Health" (SOH) bezeichnet.

Aus der US 2018/0097370 A1, der WO 2014/196933 A1 und der US 2018/0088181 A2 sind verschiedene Verfahren zur SOH-Abschätzung bekannt. Die Abschätzung des Gesundheitszustands von Wechselakkus ist jedoch mit weiteren Schwierigkeiten verbunden, da sich ihre jeweiligen Belastungen und Leistungsanforderungen für unterschiedliche Geräte und Anwendungen zum Teil massiv unterscheiden. Zwar ist es möglich, den Entladestrom im Gerät und den Ladestrom im Ladegerät zu messen, aber der genaue Ladezustand mit dem der Wechselakku in das Gerät oder in das Ladegerät eingesteckt wird, ist in der Regel nicht bekannt. Daher ist eine präzise Messung der restlichen Kapazität nicht möglich. Die Messung des Stromes direkt im Wechselakku wäre zwar eine Alternative, aber mit einem hohen Platzbedarf und mit hohen Kosten verbunden, wenn die zu messenden Ströme hoch sind, was insbesondere bei Hochleistungselektrowerkzeugen der Fall ist. Soll ein Wechselakku zudem für eine Vielzahl unterschiedlicher Geräte geeignet sein, erschwert dies die Abschätzung des SOH erheblich. Durch die unterschiedlichen Leistungsbedürfnisse der Geräte kann die Alterung eines Wechselakkus mehrere Auswirkungen haben:
- Reduzierte Restkapazität. In diesem Fall kann die erwartete Laufzeit eines Gerätes nicht mehr erreicht werden.
- Reduzierte restliche Leistungsfähigkeit durch Erhöhung des Innenwiderstandes. In diesem Fall funktionieren manche Geräte (z.B. Hochleistungwerkzeuge wie Winkelschleifer) nur noch mit reduzierter Leistung oder gar nicht mehr.

Der Erfindung liegt die Aufgabe zugrunde, eine präzise Abschätzung des Gesundheitszustands von Wechselakkus während eines Ladevorgangs zu ermöglichen. Gegenstand der vorliegenden Anmeldung sind zudem ein Ladegerät und ein Wechselakku, insbesondere ein Wechselackkupack für Elektrowerkzeuge, zur Durchführung der erfindungsgemäßen SOH-Abschätzung.

### Vorteile der Erfindung

Die Erfindung betrifft ein Verfahren zur Abschätzung des Gesundheitszustands eines Wechselakkus, insbesondere eines Wechselakkupacks für Elektrowerkzeuge. Erfindungsgemäß sind zumindest die folgenden Verfahrensschritte vorgesehen:
i. Bestimmung einer Restkapazität des Wechselakkus während eines Aufladevorgangs derart, dass
   ▪ ein erster Ladewert durch Messung einer Leerlaufspannung ermittelt wird, solange noch kein oder nur ein minimaler Ladestrom fließt,
   ▪ zumindest ein weiterer Ladewert durch Messung des Ladestroms in definierten Zeitabständen ermittelt wird, bis der Aufladevorgang abgeschlossen ist und
   ▪ eine Summe der ermittelten Ladewerte berechnet wird;
ii. Bestimmung einer restlichen Leistungsfähigkeit des Wechselakkus während des Aufladevorgangs derart, dass
   ▪ nach Erreichen einer vordefinierten Akkuspannung kurzzeitig der Ladestrom verändert und die jeweilige Akkuspannung gemessen wird und
   ▪ eine Impedanz des Wechselakkus aus dem Quotienten der Differenz der gemessenen Ladeströme und Akkuspannungen berechnet wird.

Da die Anschaffung neuer Wechselakkus in der Regel mit hohen Kosten für den Anwender verbunden ist, ist es für ihn besonders vorteilhaft, wenn ihm das erfindungsgemäße Verfahren eine möglichst kontiniuierliche Information über die Alterung eines Wechselakkus liefert, um somit besser dessen Austausch einplanen zu können. Ferner ist es ebenso vorteilhaft für den Anwender, wenn er die jeweilige Kapazität und Leistungsfähigkeit seiner Wechselakkus kennt. So kann er die einzelnen Wechselakkus je nach Leistungsbedarf oder Laufzeit der verschiedenen Geräte einer entsprechend geeigneten Anwendung zuordnen. Besonders vorteilhaft ist dies für Konzerne und Handwerker, die eine große Anzahl an Elektrowerkzeugen und Wechselakkupacks einsetzen.

Heutige Wechselakkupacks für Elektrowerkzeuge enthalten typischerweise Litium-lonen-Zellen (Li-Ion), die mit gängigen Ladegeräten in der Regel in einem sogenannten CCCV-Verfahren (Constant Current Constant Voltage) aufgeladen werden. Dabei generiert eine Ladeelektronik des Ladegeräts einen konstanten Ladestrom durch den Akkupack (Constant Current - CC), so dass die Akkuspannung steigt. Sobald die maximale Akkuspannung erreicht ist, wird diese von der Ladeelektronik konstant gehalten (Constant Voltage - CV) und der Ladestrom reduziert. Ist ein vordefinierter Minimalwert des Ladestroms erreicht, beendet die Ladeelektronik den Ladevorgang und die Akkuzellen sind vollgeladen. Der Übergang von der CC- zur CV-Phase erfolgt typischerweise bei einem Ladezustand von ca. 80 %. Da das CCCV-Verfahren dem Fachmann als solches bekannt ist, soll hierauf im Folgenden nicht weiter eingegangen werden.

Als akkubetriebenes "Elektrowerkzeug" soll zum einen jedes Gerät zur Bearbeitung von Werkstücken mittels eines elektrisch angetriebenen Einsatzwerkzeugs verstanden werden. Somit kann das Elektrowerkzeug als Elektrohandwerkzeug oder als stationäre Elektrowerkzeugmaschine ausgebildet sein. Typische Elektrowerkzeuge sind in diesem Zusammenhang Hand- oder Standbohrmaschinen, Schrauber, Schlagbohrmaschinen, Hobel, Winkelschleifer, Schwingschleifer, Poliermaschinen oder dergleichen. Aber auch Gartengeräte wie Rasentrimmer, Astsägen oder dergleichen lassen sich im Rahmen der Erfindung unter dem Begriff Elektrowerkzeug subsumieren. Weiterhin sollen Geräte als Elektrowerkzeuge verstanden werden, die typischerweise auf Baustellen zum Einsatz kommen. Beispiele hierfür sind Gebläse, Pumpen, Mischmaschinen, etc. Ebenso kann die Erfindung für Wechselakkus von akkubetriebenen Haushaltgeräten, wie Staubsauger, Mobilkochplatten, Mixer, etc. angewendet werden.

Die hier beschriebenen Wechselakkupacks weisen typischerweie ein Gehäuse auf, das über eine mechanische Schnittstelle kraft- und/oder formschlüssig lösbar mit dem Elektrowerkzeug oder dem Ladegerät verbindbar ist. Des Weiteren umfasst der Wechselakkupack zumindest eine Akkuzelle und eine elektrische Schnittstelle, über die die zumindest eine Akkuzelle mit dem Elektrowerkzeug oder dem Ladegerät elektrisch verbindbar ist. Die Akkuzelle kann als eine galvanische Zelle ausgebildet sein, die einen Aufbau aufweist, bei dem ein Zellpol an einem Ende und ein weiterer Zellpol an einem gegenüberliegenden Ende zu liegen kommen. Insbesondere weist die Akkuzelle an einem Ende einen positiven Zellpol und an einem gegenüberliegenden Ende einen negativen Zellpol auf. Bevorzugt sind die Akkuzellen als lithiumbasierte Akkuzellen, z.B. Li-Ion, Li-Po, Li-Metall oder dergleichen, ausgebildet. Die Erfindung ist aber auch auf Ni-Cd-, Ni-MH-Zellen oder andere geeignete Zellenarten anwendbar.

Die Akkuspannung des Wechselakkupacks ist in der Regel ein Vielfaches der Spannung einer einzelnen Akkuzelle und ergibt sich aus der Verschaltung (parallel oder seriell) der Akkuzellen. Bei gängigen Li-lon-Akkuzellen mit einer Zellspannung von 3,6 V ergeben sich somit beispielhafte Akkuspannungen von 3,6 V, 7,2 V, 10, 8 V, 14,4 V, 18 V, 36 V etc. Bevorzugt ist die Akkuzelle als zumindest im Wesentlichen zylinderförmige Rundzelle ausgebildet, wobei die Zellpole an Enden der Zylinderform angeordnet sind. Die elektrische Schnittstelle umfasst insbesondere zumindest zwei elektrische Kontaktelemente, die zur Übertragung von Energie ausgebildet sind. Alternativ kann die elektrische Schnittstelle aber auch ein sekundäres Ladespulenelement zur induktiven Ladung aufweisen. Zusätzlich kann die elektrische Schnittstelle weitere Kontaktelemente aufweisen, die dazu ausgebildet sind, Informationen, die vorzugsweise über eine in den Wechselakkupack integrierte Elektronik ermittelt werden, an das Elektrowerkzeug und/oder das Ladegerät zu übertragen. Dabei kann es sich neben dem Gesundheitszustand beispielsweise auch um einen Ladezustand des Wechselakkupacks, eine Temperatur innerhalb des Wechselakkupacks, eine Codierung oder einer Restkapazität des Wechselakkupacks handeln.

In einer besonderen Ausgestaltung der Erfindung wird der Aufladevorgang mit dem CCCV-Verfahren durchgeführt, wobei zur Bestimmung der Restkapazität der erste Ladewert vor der CC-Phase und die weiteren Ladewerte während der CC-Phase und der CV-Phase ermittelt werden. Somit wird vor der CC-Phase die Leerlaufspannung gemessen und im Anschluss ein so genanntes "Coulumb Counting" durchgeführt, das zur Bestimmung der Ladung im Akku die Anzahl der Elektronen erfasst.

Die Bestimmung der restlichen Leistungsfähigkeit des Wechselakkus erfolgt vorzugsweise nur während der CC-Phase, indem der Ladestrom nach Erreichen der vordefinierten Akkuspannung für eine bestimmte Zeitspanne von einem ersten Wert auf einen zweiten Wert reduziert wird. Zudem kann zur Bestimmung der restlichen Leistungsfähigkeit des Wechselakkus jeweils eine Wartezeit nach Veränderung des Ladestroms verstreichen, bis die Akkuspannung gemessen wird. Weiterhin ist vorgesehen, dass die Bestimmung der restlichen Leistungsfähigkeit in regelmäßigen Zeitabständen während des Aufladevorgangs, insbesondere während der CC-Phase, wiederholt wird.

Ergänzend ist in einem weiteren Verfahrensschritt vorgesehen, eine Temperatur des Wechselakkus zu messen. Anhand der gemessenen Temperatur kann dann die berechnete Impedanz des Wechselakkus korrigiert werden. Dies ist besonders vorteilhaft, da die Temperatur großen Einfluss auf die Impedanz des Wechselakkus und damit auch unmittelbar auf dessen aktuellen Gesundheitszustand hat.

Die Erhöhung der Impedanz im Laufe der Zeit ist ein Effekt der Alterung der Ackuzellen. Die Impedanz der stromführenden Elemente (Kontakte, Leiterbahnen, Kabel, usw.) im Wechselakku oder im Ladegerät verändert sich dagegen nur vernachlässigbar. Es ist also besonders vorteilhaft, die Spannungsmessungen direkt im Wechselakku zu realisieren, um die Impedanzen der stromführenden Elemente zu ignorieren. Es können entweder die einzelnen Zellspannungen oder die gesamte Akkuspannung gemessen werden. Diese Impedanz-Messung kann entweder einmal oder mehrmals während des Ladevorgangs stattfinden. Mehrere Messungen erlauben eine Plausibilisierung und damit eine Vermeidung von Messfehlern, aber auch eine präzisere und detailliertere Abschätzung.

Die Restkapazität, die restliche Leistungsfähigkeit und/oder der Gesundheitszustand des Wechselakkus können mit besonderem Vorteil auf einer Anzeigeeinheit ausgegeben werden. Dabei kann als Anzeigeeinheit sowohl ein Display (LCD, OLED, ePaper oder dergleichen) als auch eine LED-Anzeige des Wechselackkus, des Ladegeräts oder alternativ bzw. ergänzend ein Smartphone, Tablet, PC oder dergleichen dienen. Die Kommunikation zwischen dem Wechselakku und den genannten Anzeigegeräten erfolgt über eine entsprechende Kommunikationsschnittstelle. Dabei kann ein proprietärer BUS ebenso zum Einsatz kommen, wie eine Übertragung per Standard-Protokolle per Kabel oder Funk.

Die Erfindung betrifft auch ein Ladegerät sowie einen Wechselakku, insbesondere einen Wechselackkupack für Elektrowerkzeuge, zur Durchführung des erfindungsgemäßen Verfahrens.

### Zeichnung

Die Erfindung wird im Folgenden anhand der Figuren 1 bis 4 beispielhaft erläutert, wobei gleiche Bezugszeichen in den Figuren auf gleiche Bestandteile mit einer gleichen Funktionsweise hindeuten.

Es zeigen
- Fig. 1:: ein System bestehend aus einem Wechselakkupack für ein nicht gezeigtes Elektrowerkzeug, einem Ladegerät zum Aufladen des Wechselackupacks sowie einem externen Gerät in Form eines Smartphones, wobei insbesondere Ladegerät und Wechselakkupack zur Durchführung des erfindungsgemäßen Verfahrens dienen.
- Fig. 2:: ein Diagramm zur Veranschaulichung des erfindungsgemäßen Verfahrens anhand eines CCCV-Ladeverfahrens,
- Fig. 3:: ein Diagramm zur Veranschaulichung der Impedanz-Messung im Rahmen des erfindungsgemäßen Verfahrens,
- Fig. 4:: ein weiteres Diagramm zur Veranschaulichung der Impedanz-Messungen im Rahmen des erfindungsgemäßen Verfahrens.

### Beschreibung der Ausführungsbeispiele

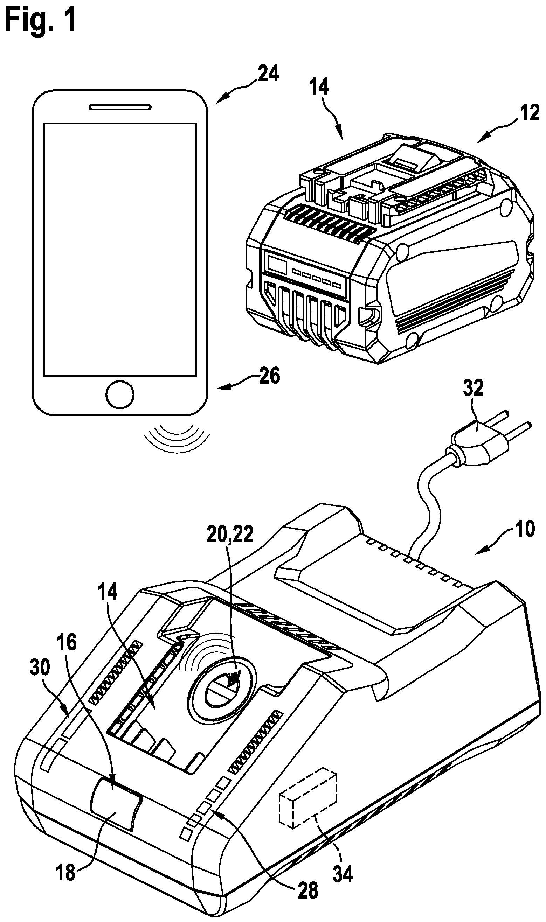

Figur 1 zeigt ein Ladegerät 10 zum Aufladen eines Wechselakkupacks 12 für eine nicht gezeigtes Elektrowerkzeug. Dem Fachmann ist die Verwendung von Wechselakkupacks für unterschiedliche Elektrowerkzeuge hinlänglich bekannt, so dass hier nicht näher darauf eingegangen werden soll.

Zum Aufladen des Wechselakkupacks 12 wird dieser mit seiner elektromechanischen Schnittstelle 14 in eine entsprechende elektromechanische Schnittstelle 14 des Ladegeräts 10 eingesteckt, so dass eine Energieübertragung vom Ladegerät 10 zum Wechselakkupack 12 erfolgt. Gleichzeitig können über die elektromechanischen Schnittstellen 14 Daten bzgl. der Ladeparamenter, wie Temperatur, Ladezustand, Restkapazität und dergeleichen, und/oder des Gesundheitszustands des Wechselakkupacks 12 übertragen werden. Dem Fachmann ist die Auslegung der elektromechanischen Schnittstellen 14 von Akkupack, Ladegerät und Elektrowerkzeug zur elektrischen Versorgung des Elektrowerkzeugs einerseits und zum Aufladen des Wechselakkupacks 12 mittels des Ladegeräts 10 andererseits bekannt, so dass hierauf nicht weiter eingegangen werden soll, zumal dies für die Erfindung als solche ohne weitere Bedeutung ist. Weiterhin sei angemerkt, dass die Erfindung ohne Einschränkung auch auf kabellos, insbesondere induktiv, arbeitende Ladegeräte und Wechselakkus anwendbar ist.

Mittels einer Bedieneinheit 16 lassen sich durch einen Anwender beispielsweise unterschiedliche Lademodi am Ladegerät 10 einstellen. Dabei kann zwischen einem "Standard"-Modus (in der Regel das CCCV-Ladeverfahren), einem "Boost"-Modus mit erhöhtem Ladestrom und sehr kurzer Ladezeit, einem "Long-Life"-Modus mit besonders geringem Ladestrom und sehr langer Ladezeit, einem "Storage"-Modus mit einem geringen Ladestrom und verlängerter Ladezeit sowie einem "Flight"-Modus mit einem Ladestroum und einer Ladezeit entsprechend dem "Storage"-Modus aber demgegenüber verringerter Ladegrenze unterschieden werden. Die einzelnen Lademodi seien hier nur exemplarisch genannt und schränken die Erfindung nicht ein. Weiterhin dient die Bedieneinheit 16 als Anzeige 18 des aktuell eingestellten Lademodus über eine oder mehrere LEDs und/oder ein Display mit unterschiedlichen Farben und/oder Blinkfrequenzen.

Über eine Schnittstelle 20, die - wie bereits erwähnt - als Funkschnittstelle 22 (z.B. Bluetooth, WLAN, NFC, Zigbee, LoRa, GSM, UMTS oder dergleichen) aber auch als kabelgebundene Schnittstelle (z.B. USB, Ethernet, Thunderbolt, Lightning, RS232 oder dergleichen) der elektromechanischen Schnittstelle 14 ausgebildet sein kann, ist es dem Anwender alternativ oder ergänzend möglich, den Lademodus mittels eines externen Geräts 24 (z.B. Smartphone, Tablet, PC, Fernbedienung, etc.) mit entsprechender Gegenschnittstelle 26 umzuschalten. Ferner erhält der Anwender mittels der Schnittstellen 20, 22, 26 eine Rückmeldung auf das externe Gerät 24 über den aktuell eingestellten Lademodus, die oben erwähnten Ladeparameter und/oder den Gesundheitszustand des Wechselakkupacks 12.

Das Ladegerät 10 verfügt des weiteren über eine Ladezustandsanzeige 28, die in mehrere Anzeigesegmente für unterschiedliche Ladezustandsbereiche (z.B. <= 20 %, <= 40 %, <= 60 %, <= 80 %, <= 100 %) aufgeteilt ist. Somit kann der Anwender schnell und einfach den Ladezustand des eingesteckten Wechselakkupacks 12 erkennen. Die Ladezustandsanzeige 28 kann derart ausgebildet sein, dass jeweils sämtliche Segmente zur Anzeige des aktuell eingestellten Lademodus herangezogen werden. Alternativ ist es aber auch denkbar, dass sich die Segmente immer auf den Vollladezustand des zu ladenden Wechselakkupacks 12 beziehen, wobei das Ende eines Ladevorgangs des aktuell eingestellten Lademodus dann beispielsweise durch ein Blinken oder eine andere Farbe einzelner oder mehrerer Segmente bis zur aktuellen Ladegrenze angezeigt wird. Mit einer Statusanzeige 30 kann das Ladegerät 10 dem Anwender etwaige Fehler im Ladegerät 10 und/oder im Wechselakkupack 12, wie zum Beispiel eine Übertemperatur oder einen kritischen Abbruch des Ladevorgangs, aber auch einen kritischen Gesundheitszustand des Wechselakkupacks 12 signalisieren. Die Anzeigen 18, 28, 30 können durch ein- oder mehrfarbige LED, durch LCD- bzw. OLED-Elemente, durch ePaper oder dergleichen realisiert sein. Ergänzend oder alternativ können einzelne oder alle Anzeigen 18, 28, 30 auch als akustische und/oder haptische Signalgeber umgesetzt sein. Dabei kommt als akustischer Signalgeber beispielsweise ein Lautsprecher, insbesondere Piezo-Lautsprecher, und als haptischer Signalgeber ein Vibrationsgeber in Gestalt eines Elektromotors mit durch diesen angetriebener Unwuchtscheibe, in Frage.

Ist ein Wechselakkupack 12 mit seiner elektromechanischen Schnittstelle 14 in die elektromechanische Schnittstelle 14 des Ladegeräts 10 eingesteckt, startet das Ladegerät 10 den Aufladevorgang automatisch mit dem Einstecken eines Netzsteckers 32 des Ladegeräts 10 in eine Steckdose. Ebenso kann der Ladevorgang bei eingesteckten Netzstecker 32 durch das Einstecken des Wechselakkupacks 12 in das Ladegerät 10 und/oder nach Betätigung der Bedieneineheit 16 gestartet werden. Der Ladevorgang wird regulär beendet, wenn der Wechselakkupack 12 vollgeladen ist und/oder der Anwender den Wechselakkupack 12 aus dem Ladegerät 10 entnimmt. Zudem beendet das Ladegerät 10 den Aufladevorgang im Falle eines detektierten Fehlers oder bei Erreichen eines kritischen Gesundheitszustands des Wechselakkupacks 12.

Weiterhin ist ein Zurücksetzen des Ladegeräts 10 in einen Werkszustand mittels der Schnittstelle 20 und/oder der Bedieneinheit 16 möglich. Dazu umfasst das Ladegerät 10 eine Kontrolleinheit 34, beispielsweise in Gestalt eines nicht gezeigten aber dem Fachmann bekannten Microprozessors, mit einer entsprechenden Zurücksetz- bzw. Reset-Funktion, die auf ein Betätigen der Bedieneinheit 16 reagiert.

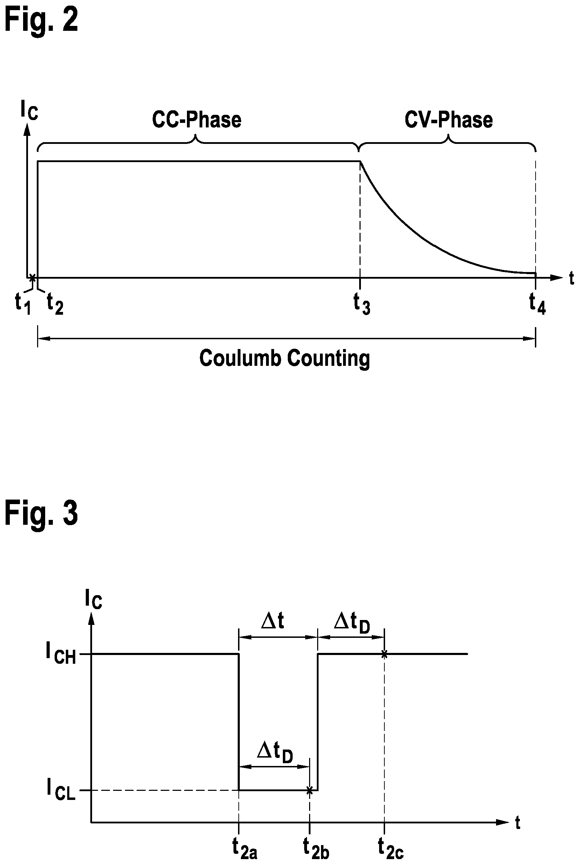

Anhand von Figur 2 soll nun das erfindungsgemäße Verfahren zur Abschätzung des Gesundheitszustands auf Basis der Restkapazität und der Leistungsfähigkeit des Wechselakkupacks 12 erläutert werden. In Figur 2 ist der Verlauf des Ladestroms Ic über die Zeit t aufgetragen.

In einem ersten Verfahrensschritt I erfolgt eine Bestimmung der Restkapazität des Wechselakkupacks 12 während des Aufladevorgangs derart, dass ein erster Ladewert C₁ durch Messung einer Leerlaufspannung Uₗ (auch Open Circuit Voltage genannt) ermittelt wird, solange noch kein oder nur ein minimaler Ladestrom I_{C} fließt. Nachdem der Wechselackupack 12 in das Ladegerät 10 eingesteckt wurde, erfolgt zum Zeitpunkt t₁ eine Messung der Leerlaufspannung Uₗ. Diese Messung kann im Ladegerät 10 (direkte Messung der Akkuspannung) und/oder im Wechselakkupack 12 erfolgen, wobei entweder die gesamte Akkuspannung oder die Zellspannungen der einzelnen Akkuzellen erfasst werden. Anhand der Leerlaufspannung Uₗ lässt sich der Ladezustand des Wechselakkupacks 12 (zum Beispiel die Ladung in Ah) vor dem eigentlichen Ladevorgang durch eine hinterlegte Ladezustands-/Leerlaufspannungskurve bzw. mittels einer entsprechenden Look-Up-Tabelle ermitteln. Das Verhältnis zwischen Ladezustand und Leerlaufspannung kann je nach Akku sehr unterschiedlich sein, weshalb individuelle Kurven und/oder Tabellen für jeden Wechselakkupack 12 sinnvoll sind.

In definierten Zeitabständen wird dann zumindest ein weiterer Ladewert Cₙ durch Messung des entsprechenden Ladestroms I_{Cn} ermittelt, bis der Aufladevorgang abgeschlossen ist. Dazu startet das Ladeverfahren zum Zeitpunkt t₂ nach Messung der Leerlaufspannung Uₗ. Das Ladegerät 10 erzeugt einen Ladestrom Ic, der bis zu einer maximalen Akkuspannung konstant ist (CC-Phase) und bei Erreichen der maximaler Akkuspannung zum Zeitpunkt t₃ herunter geregelt wird, damit die Akkuspannung konstant bleibt (CV-Phase).

Während des gesamten Ladevorgangs wird der Ladestrom I_{Cn} in definierten Intervallen vom Ladegerät 10 gemessen. Diese Werte werden von dem Mikrocontroller der Kontrolleinheit 34 in einem Zähler summiert. Am Ende des Ladevorgangs zum Zeitpunkt t₄ schaltet sich das Ladegerät 10 ab, sobald während der CV-Phase der Ladestrom I_{C} einen vordefinierten Minimalwert I_{CT} erreicht hat. Dann ergibt die Summe der erfassten Ladestromwerte I_{Cn} die komplette Ladung Σₙ Cₙ (zum Beispiel in Ah) des Wechselakkupacks 12. Dieses Verfahren wird auch "Coulomb Counting" genannt, da es die Anzahl der Elektronen erfasst. Zum Abschluss des ersten Verfahrensschritts I wird schließlich eine Summe der ermittelten Ladewerte C₁ + Σₙ Cₙ berechnet, anhand der sich die restliche Gesamtkapazität, die noch in dem Wechselakkupack 12 eingeladen werden kann, ergibt.

In einem weiteren Verfahrensschritt II erfolgt die Bestimmung einer restlichen Leistungsfähigkeit des Wechselakkupacks 12 während des Aufladevorgangs derart, dass zunächst nach Erreichen einer vordefinierten Akkuspannung U_{CT} kurzzeitig der Ladestrom I_{C} verändert und die jeweilige Akkuspannung U_{C} gemessen wird. Danach erfolgt die Berechnung einer Impedanz Z des Wechselakkupacks 12 aus dem Quotienten der Differenz der gemessenen Akkuspannungen und Ladeströme.

Wenn die vordefinierte Akkuspannung U_{CT} erreicht ist, wird gemäß Figur 3 der Ladestrom Ic während der CC-Phase (vgl. Figur 2) zu einem Zeitpunkt t₂ₐ für eine bestimmte Zeitspanne Δt von einem ersten Wert I_{CH} auf einen zweiten, vordefinierten Wert I_{CL} reduziert. Nach Ablauf einer kurzen Wartezeit Δt_{D} zur Relaxation der Akkuspannung (zum Beispiel ein paar Sekunden) wird die Akkuspannung U_{C1} zu einem Zeitpunkt t_{2b} ein erstes Mal gemessen. Nach Ablauf der Zeitspanne Δt wird der Ladestrom I_{C} wieder auf den ersten Wert I_{CH} erhöht und nach der gleichen Wartezeit Δt_{D} die Akkuspannung U_{C2} zu einem Zeitpunkt t_{2c} erneut gemessen. Alternativ kann die erste Messung auch bei dem ersten Ladestromwert I_{CH} und die zweite Messung bei dem reduzierten Ladestromwert I_{CL} erfolgen. Zudem ist es nicht zwingend notwendig, dass die Wartezeiten Δt_{D} vor den Zeitpunkten t_{2b} und t_{2c} gleich lang sind.

Da beide Messungen nur wenige Sekunden auseinander liegen, verändert sich der Ladezustand nicht bzw. nur unwesentlich. Durch Bildung des Quotienten aus der Differenz beider Akkuspannungwerte U_{C2} - U_{C1} und der zugehörigen Ladestromwerte I_{CH} - I_{CL} lässt sich schließlich näherungsweise die Impedanz Z (genau genommen die Gleichstromimpedanz bzw. der Innenwiderstand) des Wechselackupacks 12 ermitteln. Dabei gilt, dass sich die Leistungsfähigkeit des Wechselackkupacks 12 reziprok zur ermittelten Impedanz Z verhält. Sprich, je höher die ermittelte Impedanz Z ist, desto geringer ist die Leistungsfähigkeit des Wechselakkupacks 12. Darüber hinaus gilt zu berücksichtigen, dass die Impedanz Z des Wechselackkupacks 12 mit seinem Alter zunimmt.

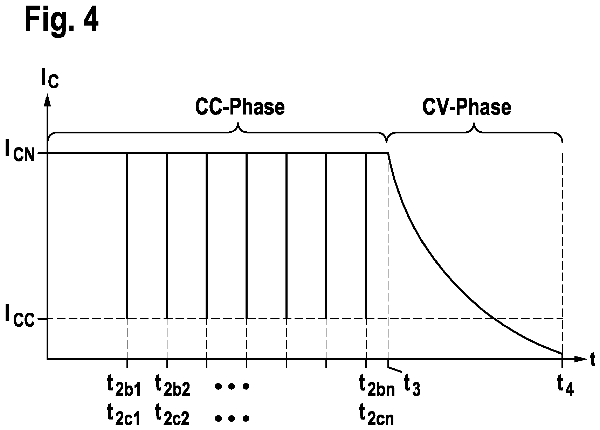

Bei der Ermittlung der Impedanz Z im Ladegerät 10 können zudem folgende Aspekte von Bedeutung sein:
- Die Impedanz Z eines Akkus ist sehr temperaturabhängig. Es ist daher sinnvoll, die Temperatur T des Wechselakkupacks 12 während der Impedanzermittlung zu erfassen und die Leistungsfähigkeit auf Basis der Impedanz Z in Abhängigkeit von dieser Temperatur T zu bestimmen.
- Die Erhöhung der Impedanz Z mit zunehmendem Alter eines Akkus ist ein Effekt der Alterung der Akkuzellen. Die Impedanz der stromführenden Elemente (Kontakte, Leiterbahnen, Kabeln, usw.) im Wechselakkupack 12 oder im Ladegerät 10 ändert sich dagegen kaum. Es ist also besonders vorteilhaft, die Spannungsmessungen direkt im Wechselakkupack 12 zu realisieren, um Einflüsse der Impedanzen der stromführenden Elemente auszuschließen. Dabei können entweder die einzelnen Zellspannungen oder die gesamte Akkuspannung des Wechselakkupacks 12 gemessen werden.
- Die oben erläuterte Impedanz-Messung kann gemäß Figur 4 auch mehrmals während des Ladevorgangs innerhalb der CC-Phase stattfinden. Mehrere Messungen zu den Zeitpunkten t_{2b1}, t_{2b2},... t_{2bn} und t_{2c1}, t_{2c2},... t_{2cn} erlauben eine Plausibilisierung und damit ein Vermeiden von Messfehlern sowie die Realisierung einer präziseren und detaillierteren Abschätzung des Gesundheitszustands des Wechselakkupacks 12.

Die Messungen, die für die SOH-Abschätzung nötig sind (z.B. Spannungen, Temperaturwerte, etc.), können im Ladegerät 10 oder im zu ladenden Wechselakkupack 12 erfolgen. Werden sie im Wechselakkupack 12 durchgeführt, können die ermittelten Werte über die bereits in Verbindung mit Figur 1 erläuterten Schnittstellen 14 per Kontakverbindung (z.B. kabelgebunden) und/oder 20 bzw. 22 per kontakt- bzw. kabelloser Verbindung an das Ladegerät 10 gesendet werden. Die Auswertung der Messungen ist dann entweder im Ladegerät 10 oder ergänzend bzw. alternativ über die Funkschnittstellen 22 und 26 in dem externen Gerät 24 möglich. Erfolgt die Auswertung im Ladegerät 10, können die Ergebnisse direkt über die Ladezustandsanzeige 28 und/oder die Statusanzeige 30 ausgegeben werden. Erfolgt sie im externen Gerät 24, ist eine Anzeige über dessen Display mit mehr Details und Erläuterungen möglich. Selbstverständlich ist es ebenso möglich, die Berechnung und Auswertung im Ladegerät 10, im Wechselakkupack 12 oder im externen Gerät 24 und die Anzeige der Ergebnisse im jeweils anderen Gerät 10, 12 oder 24 durchführen zu lassen. Da die Auswertung in der Regel komplex ist und eine große Menge an Daten (hinterlegte Kurven und Tabelle für unterschiedliche Wechselakkupacks) und Ressourcen (komplexe Formeln) benötigt, ist es besonders vorteilhaft wenn sie direkt im externen Gerät 24 erfolgt. So werden Kosten für Prozessoren und ggf. Bauraum im Ladegerät 10 gespart, und es können kostengünstigere Microprozessoren als Kontrolleinheit 34 zum Einsatz kommen. Zusätzlich erlaubt eine Auswertung im externen Gerät 24 eine nachträgliche Optimierung anhand von Datensammlungen, beispielsweise über Updates der Applikation, die auf dem externen Gerät 24 installiert sind. Des Weiteren können Daten von Wechselakkupacks 12, die zu dem Zeitpunkt, als das Ladegerät 10 verkauft wurde, noch nicht existierten, nachträglich im externen Geräte 24 hinterlegt werden. Erfolgt die Auswertung im Ladegerät 10 mit einer entsprechend leistungsstarken Kontrolleinheit 34, ist selbstverständlich auch ein Datenupdate über dessen Schnittstellen 20, 22 möglich.

Es sei abschließend darauf hingewiesen, dass die gezeigten Ausführungsbeispiele weder auf die Figuren 1 bis 4 noch auf das beschriebene CCCV-Ladeverfahren beschränkt sind. So kann die Erfindung auch für ein anderes, geeignetes Ladeverfahren mit abweichenden Ladekurven zum Einsatz kommen. Ebenso ist es möglich, mehr als nur zwei unterschiedliche Ladeströme I_{CH}, I_{CL} und Akkuspannungen U_{C1}, U_{C2} für die Bestimmung der Impedanz Z bzw. der restlichen Leistungsfähigkeit des Wechselakkupacks 12 zu entsprechend geeigneten Abtastzeitpunkten heranzuziehen.

## Patentansprüche

1. Verfahren zur Abschätzung des Gesundheitszustands eines Wechselakkus (12), insbesondere eines Wechselakkupacks (12) für Elektrowerkzeuge, mit folgenden Verfahrensschritten:
i. Bestimmung einer Restkapazität des Wechselakkus (12) während eines Aufladevorgangs derart, dass
▪ ein erster Ladewert (C₁) durch Messung einer Leerlaufspannung (Uₗ) ermittelt wird, solange noch kein oder nur ein minimaler Ladestrom (I_{C}) fließt,
▪ zumindest ein weiterer Ladewert (Cₙ) durch Messung des Ladestroms (I_{Cn}) in definierten Zeitabständen (t_{2b}, t_{2c}) ermittelt wird, bis der Aufladevorgang abgeschlossen ist und
▪ eine Summe der ermittelten Ladewerte (C₁ + Σ*ₙ Cₙ*) berechnet wird; **gekennzeichnet durch** die folgenden Verfahrensschritte:
ii. Bestimmung einer restlichen Leistungsfähigkeit des Wechselakkus (12) während des Aufladevorgangs derart, dass
▪ nach Erreichen einer vordefinierten Akkuspannung (U_{CT}) kurzzeitig der Ladestrom (I_{C}, I_{CH}, I_{CL}) verändert und die jeweilige Akkuspannung (Uc, U_{C1}, U_{C2}) gemessen wird.

2. Verfahren nach Anspruch 1, **dadurch gekennzeichnet, dass** eine Impedanz (Z) des Wechselakkus (12) aus dem Quotienten der Differenz der gemessenen Ladeströme (I_{CH} - I_{CL}) und Akkuspannungen (U_{C1} - U_{C2}) berechnet wird.

3. Verfahren nach Anspruch 2, **dadurch gekennzeichnet, dass** der Aufladevorgang mit einem CCCV-Verfahren durchgeführt wird, wobei zur Bestimmung der Restkapazität der erste Ladewert (C₁) vor der CC-Phase und die weiteren Ladewerte (Cₙ) während der CC-Phase und der CV-Phase ermittelt werden.

4. Verfahren nach Anspruch 3, **dadurch gekennzeichnet, dass** die Bestimmung der restlichen Leistungsfähigkeit des Wechselakkus (12) nur während der CC-Phase erfolgt, indem der Ladestrom (I_{C}) nach Erreichen der vordefinierten Akkuspannung (U_{CT}) für eine bestimmte Zeitspanne (Δt) von einem ersten Wert (I_{CH}) auf einen zweiten Wert (I_{CL}) reduziert wird.

5. Verfahren nach einem der Ansprüche 2 bis 4, **dadurch gekennzeichnet, dass** zur Bestimmung der restlichen Leistungsfähigkeit des Wechselakkus (12) jeweils eine Wartezeit (Δt_{D}) nach Veränderung des Ladestroms (Ic, I_{CH}, I_{CL}) verstreicht, bis die Akkuspannung (Uc, U_{C1}, U_{C2}) gemessen wird.

6. Verfahren nach einem der Ansprüche 2 bis 5, **dadurch gekennzeichnet, dass** die Bestimmung der restlichen Leistungsfähigkeit in regelmäßigen Zeitabständen (t_{2b1}, t_{2b2},... t_{2bn}; t_{2c1}, t_{2c2},... t_{2cn}) während des Aufladevorgangs, insbesondere während der CC-Phase, wiederholt wird.

7. Verfahren nach einem der Ansprüche 2 bis 6, **dadurch gekennzeichnet, dass** in einem weiteren Verfahrensschritt eine Temperatur (T) des Wechselakkus (12) gemessen wird.

8. Verfahren nach Anspruch 7, **dadurch gekennzeichnet, dass** die berechnete Impedanz (Z) des Wechselakkus (12) anhand der gemessenen Temperatur (T) korrigiert wird.

9. Verfahren nach einem der Ansprüche 2 bis 8, **dadurch gekennzeichnet, dass** die Restkapazität, die restliche Leistungsfähigkeit und/oder der Gesundheitszustand des Wechselakkus (12) auf einer Anzeigeeinheit (18, 24, 28, 30) ausgegeben werden.

10. Ladegerät (10) konfiguriert zur Durchführung des Verfahrens nach einem der vorhergehenden Ansprüche.

11. Wechselakku (12), insbesondere Wechselakkupack (12), konfiguriert zur Durchführung des Verfahrens nach einem der vorhergehenden Ansprüche 1 bis 9.

## Claims

1. Method for estimating the state of health of an exchangeable rechargeable battery (12), in particular of an exchangeable rechargeable battery pack (12) for electric power tools, comprising the following method steps:
i. determining a remaining capacity of the exchangeable rechargeable battery (12) during a charging process in such a way that
• a first charging value (C₁) is ascertained by measuring an open-circuit voltage (Uₗ) as long as there is still no or only a minimal charging current (I_{C}) flowing,
• at least one further charging value (Cₙ) is ascertained by measuring the charging current (I_{Cn}) at defined time intervals (t_{2b}, t_{2c}) until the charging process is concluded, and
• a sum of the ascertained charging values (C₁ + Σ*ₙ Cₙ*) is calculated;
**characterized by** the following method steps:
ii. determining a remaining performance of the exchangeable rechargeable battery (12) during the charging process in such a way that
• after a predefined rechargeable battery voltage (U_{CT}) has been reached, the charging current (I_{C}, I_{CH}, I_{CL}) is briefly changed and the respective rechargeable battery voltage (U_{C}, U_{C1}, U_{C2}) is measured.

2. Method according to Claim 1, **characterized in that** an impedance (Z) of the exchangeable rechargeable battery (12) is calculated from the quotient of the difference between the measured charging currents (I_{CH} - I_{CL}) and rechargeable battery voltages (U_{C1} - U_{C2}) .

3. Method according to Claim 2, **characterized in that** the charging process is carried out using a CCCV method, wherein, for the purpose of determining the remaining capacity, the first charging value (C₁) is ascertained before the CC phase and the further charging values (Cₙ) are ascertained during the CC phase and the CV phase.

4. Method according to Claim 3, **characterized in that** the remaining performance of the exchangeable rechargeable battery (12) is determined only during the CC phase by virtue of the fact that after the predefined rechargeable battery voltage (U_{CT}) has been reached, the charging current (I_{C}) is reduced for a specific time period (Δt), from a first value (I_{CH}) to a second value (I_{CL}).

5. Method according to any of Claims 2 to 4, **characterized in that** for the purpose of determining the remaining performance of the exchangeable rechargeable battery (12), a waiting time (Δt_{D}) after the change in the charging current (I_{C}, I_{CH}, I_{CL}) elapses in each case until the rechargeable battery voltage (U_{C}, U_{C1}, U_{C2}) is measured.

6. Method according to any of Claims 2 to 5, **characterized in that** the determination of the remaining performance is repeated at regular time intervals (t_{2b1}, t_{2b2}, ..., t_{2bn}; t_{2c1}, t_{2c2}, ..., t_{2cn}) during the charging process, in particular during the CC phase.

7. Method according to any of Claims 2 to 6, **characterized in that** a temperature (T) of the exchangeable rechargeable battery (12) is measured in a further method step.

8. Method according to Claim 7, **characterized in that** the calculated impedance (Z) of the exchangeable rechargeable battery (12) is corrected on the basis of the measured temperature (T).

9. Method according to any of Claims 2 to 8, **characterized in that** the remaining capacity, the remaining performance and/or and the state of health of the exchangeable rechargeable battery (12) are output on an indicating unit (18, 24, 28, 30).

10. Charger (10) configured to carry out the method according to any of the preceding claims.

11. Exchangeable rechargeable battery (12), in particular exchangeable rechargeable battery pack (12), configured to carry out the method according to any of the preceding Claims 1 to 9.

## Revendications

1. Procédé permettant d'estimer l'état de santé d'une batterie rechargeable (12), en particulier d'un blocbatterie rechargeable (12) pour outils électriques, comprenant les étapes de procédé suivantes consistant à :
i. déterminer une capacité résiduelle de la batterie rechargeable (12) pendant un processus de recharge de sorte que
• une première valeur de charge (C₁) est établie en mesurant une tension en circuit ouvert (U₁) tant qu'aucun courant de charge (I_{C}) ne circule ou seul un courant de charge minimal circule,
• au moins une autre valeur de charge (Cₙ) est établie en mesurant le courant de charge (I_{Cn}) à intervalles de temps définis (t_{2b}, t_{2c}) jusqu'à ce que le processus de recharge soit terminé, et
• une somme des valeurs de charge établies (C₁ + ΣₙCₙ) est calculée ;
**caractérisé par** les étapes de procédé suivantes consistant à :
ii. déterminer une puissance résiduelle de la batterie rechargeable (12) pendant le processus de recharge de sorte que
• après qu'une tension de batterie prédéfinie (U_{CT}) est atteinte, le courant de charge (I_{C}, I_{CH}, I_{CL}) est modifié brièvement et la tension de batterie respective (U_{C}, U_{C1}, U_{C2}) est mesurée.

2. Procédé selon la revendication 1, **caractérisé en ce qu'**une impédance (Z) de la batterie rechargeable (12) est calculée à partir du quotient de la différence des courants de charge mesurés (I_{CH} à I_{CL}) et des tensions de batterie (U_{C1} à U_{C2}) .

3. Procédé selon la revendication 2, **caractérisé en ce que** le processus de charge est effectué par un procédé CCCV, dans lequel, pour déterminer la capacité résiduelle, la première valeur de charge (C₁) est établie avant la phase CC et les autres valeurs de charge (Cₙ) sont établies pendant la phase CC et la phase CV.

4. Procédé selon la revendication 3, **caractérisé en ce que** la détermination de la puissance résiduelle de la batterie rechargeable (12) n'est effectuée que pendant la phase CC **en ce qu'**après que la tension de batterie prédéfinie (U_{CT}) a été atteinte, le courant de charge (I_{C}) est réduit pendant une période de temps déterminée (Δt) d'une première valeur (I_{CH}) à une deuxième valeur (I_{CL}).

5. Procédé selon l'une quelconque des revendications 2 à 4, **caractérisé en ce que** pour déterminer la puissance résiduelle de la batterie rechargeable (12), respectivement un temps d'attente (Δt_{D}) s'écoule après la variation du courant de charge (I_{C}, I_{CH}, I_{CL}) jusqu'à ce que la tension de batterie (U_{C}, U_{C1}, U_{C2}) soit mesurée.

6. Procédé selon l'une quelconque des revendications 2 à 5, **caractérisé en ce que** la détermination de la puissance résiduelle est répétée à des intervalles de temps réguliers (t_{2b1}, t_{2b2}, ... t_{2bn} ; t_{2c1}, t_{2c2}, ... t_{2cn}) pendant le processus de recharge, en particulier pendant la phase CC.

7. Procédé selon l'une quelconque des revendications 2 à 6, **caractérisé en ce qu'**une température (T) de la batterie rechargeable (12) est mesurée dans une autre étape de procédé.

8. Procédé selon la revendication 7, **caractérisé en ce que** l'impédance calculée (Z) de la batterie rechargeable (12) est corrigée à l'aide de la température mesurée (T).

9. Procédé selon l'une quelconque des revendications 2 à 8, **caractérisé en ce que** la capacité résiduelle, la puissance résiduelle et/ou l'état de santé de la batterie rechargeable (12) sont sortis sur une unité d'affichage (18, 24, 28, 30).

10. Chargeur (10), configuré pour effectuer le procédé selon l'une quelconque des revendications précédentes.

11. Batterie rechargeable (12), en particulier blocbatterie rechargeable (12), configurée pour effectuer le procédé selon l'une quelconque des revendications précédentes 1 à 9.
